# EUROPEAN PATENT APPLICATION

(11) **EP 2 219 226 A2**
(43) Date of publication of application: **18.08.2010**
(21) Application number: 09173530.8
(22) Date of filing: 20.10.2009
(51) Int. Cl.: H01L 31/0224

(54) **Electrode structure and solar cell comprising the same**

(30) Priority: 11.02.2009 TW 98201970 U
(71) Applicant: Neo Solar Power Corp., Hsinchu City 300 (TW)
(72) Inventor: Hsu, Kuo-Chiang, 300, Hsinchu City (TW); Tai, Yu-Wei, 300, Hsinchu City (TW); Chen, Yang-Fang, 300, Hsinchu City (TW); Wu, Meng-Hsiu, 300, Hsinchu City (TW)
(74) Representative: 2K Patentanwälte Blasberg Kewitz & Reichel

(57) **Abstract**

An electrode structure (2) is disposed in a substrate (21) of a solar cell. The electrode structure includes a plurality of bus bar electrodes (22) and a plurality of finger electrodes (23). The bus bar electrodes are alternately disposed on the substrate. The finger electrodes are disposed on the two sides of the bus bar electrodes. Each of the finger electrodes has a first terminal (231) and a second terminal (232). The first terminals of the finger electrodes are connected to one of the bus bar electrodes. The size (d1) of the first terminal (231) is larger than that (d2) of the second terminal (232).

## Description

### BACKGROUND OF THE INVENTION

### Field of Invention

The present invention relates to an electrode structure and, in particular, to an electrode structure applying in a solar cell.

### Related Art

Silicon is the most commonly used electronic material in semiconductor industry. The production and supply of the silicon wafers are a rather matured technology. Since the energy gap of the silicon is suitable for absorbing sun light, the silicon solar cell now becomes the most popular solar cell used nowadays. In general, the structure of the single crystal silicon solar cell or a polysilicon solar cell includes a conducting grid, an antireflective layer, an N-type semiconductor layer, a P-type semiconductor layer, and a back contact electrode.

When the P-type semiconductor layer and the N-type semiconductor layer contact each other, the electrons in the N-type semiconductor layer will flow into the P-type semiconductor layer to fill up the holes in the P-type semiconductor layer. A carrier depletion zone is formed near the P-N contact surface by combining the electrons and holes. The P-type and N-type semiconductor layers also contain negative electric charges and positive electric charges, respectively; hence a built-in electric field is formed. When the sun light irradiates the P-N structure, the P-type and N-type semiconductor layers absorb the sun light and generate a pair of electron and hole. Because the built-in electric field provided by the depletion zone may allow the electrons generated in the semiconductor flow in the cell, a complete solar cell may be formed if the electrons are induced via the electrode.

The material of the external electrode is usually various combinations of Ni, Ag, Al, Cu, and Pd. In order to conduct a sufficient electron flow, a conductive area between the electrode and the substrate has to be large enough. However, in order to reduce the opacity of the external electrode to the sun light, the surface of the substrate covered by the external electrode has to be as small as possible. Therefore, the external electrode structure has to be able to include the properties of low resistance and low opacity. Therefore, the current external electrode can be mainly divided into two structures: a bus bar electrode and a finger electrode. The size of the cross section of the bus bar electrode is larger than that of the finger electrode. In other words, the bus bar electrode is like the trunk and the finger electrode is like the branches of the tree distributing all over the surface of the solar cell. Thus, the electrons are gathered together to the bus bar electrode via the finger electrode and outputted to the external load via the bus bar electrode. In other words, the bus bar electrode, which is larger in size, helps increase the electron flow and the finger electrode, which is smaller in size, helps reduce the opacity.

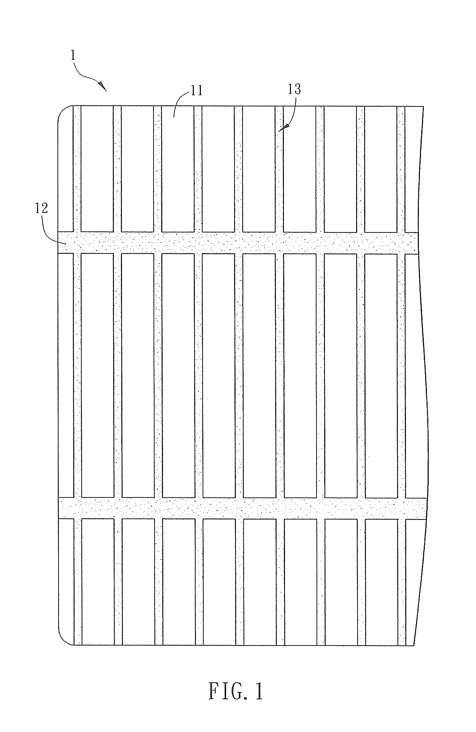

FIG. 1 is a schematic view of an electrode structure 1 of a conventional solar cell. With reference to FIG. 1, two bus bar electrodes 12 and a plurality of finger electrodes 13 are disposed on a semiconductor substrate 11. The electrons generated in the semiconductor travel to the bus bar electrode 12 via the finger electrodes 13 and are led out by the bus bar electrode 12, for providing the electric energy to the load or storing the electric energy.

The efficiency theory value of the single crystal silicon solar cell can be as high as 27%; 24% during research and development; and about 12-14% after product commercialized. Therefore, it is an important subject to provide an electrode structure and a solar cell with the properties of low resistance and low opacity for enhancing the efficiency of photoelectric transduction.

### SUMMARY OF THE INVENTION

In view of the foregoing, the present invention is to provide an electrode structure and a solar cell having properties of low resistance and low opacity to enhance the photoelectric transduction efficiency.

To achieve the above, an electrode structure of the present invention discloses a substrate disposed in a solar cell. The electrode structure includes a plurality of bus bar electrodes and a plurality of finger electrodes. The bus bar electrodes are disposed alternately on the substrate and the finger electrodes are disposed on two sides of the bus bar electrodes. Each of the finger electrodes has a first terminal and a second terminal. The first terminals of the finger electrodes are connected to one of the bus bar electrodes, and the size of the first terminal is larger than that of the second terminal.

Any of the finger electrodes is a structure converging from the first terminal to the second terminal.

To achieve the above, a solar cell of the present invention includes a substrate and an electrode structure disposed on a surface of the substrate. The electrode structure includes a plurality of bus bar electrodes and a plurality of finger electrodes. The bus bar electrodes are disposed alternately on the substrate. The finger electrodes are disposed on two sides of the bus bar electrodes. Each of the finger electrodes has a first terminal and a second terminal. The first terminals of the finger electrodes are connected to one of the bus bar electrodes and the size of the first terminal is larger than that of the second terminal.

Any of the finger electrodes is a structure converging from the first terminal to the second terminal.

Because the electrical performance of the solar cell is closely related to the light utilization rate and electron transmission resistance, the opacity is reduced by decreasing the width of the finger electrode in prior art. However, when the width of the finger electrode is reduced to a certain extend, the electrons pass through a narrower conductive channel and this leads the resistance value to rise. Meanwhile, the electric energy loss in the electrons is caused during the electron transmission process (e.g. the electric energy is converted into the thermal energy and dispersed). On the contrary, the width of the finger electrode has to be widened to prevent the electric energy loss in the electron from occurring during the transmission process. Nonetheless, the opacity of such finger electrode structure must increase. Therefore, the electrode structure and solar cell of the present invention discloses that the sizes of the first terminals of the finger electrodes must be larger than those of the second terminals, such that the solar cell may effectively reduce the resistance received as the electrons flow without increasing the width of the finger electrode, i.e. maintain a low opacity, by only changing the shape of the finger electrode, which is, the first terminal of the finger electrode is larger than the second terminal. Compared to the prior art, a low opacity and a low resistance may be taken care of by the structural change of the finger electrode, thus the present invention may effectively enhance the photoelectric transduction efficiency of the entire solar cell.

### BRIEF DESCRIPTION OF THE DRAWINGS

The invention will become more fully understood from the detailed description and accompanying drawings, which are given for illustration only, and thus are not limitative of the present invention, and wherein:

FIG. 1 is a schematic view of a conventional electrode structure;

FIG. 2 is a schematic view of an electrode structure and a solar cell with the electrode structure according to an embodiment of the present invention; and

FIG. 3 is a schematic view of the electrode structure according to the embodiment of the present invention in various aspects.

### DETAILED DESCRIPTION OF THE INVENTION

The present invention will be apparent from the following detailed description, which proceeds with reference to the accompanying drawings, wherein the same references relate to the same elements.

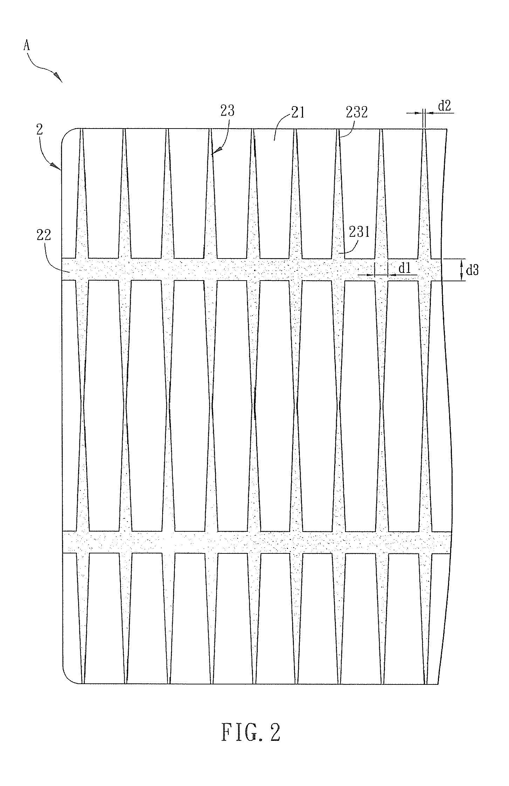

FIG. 2 is a schematic view of an electrode structure 2. With reference to FIG. 2, the electrode structure 2 is disposed on a substrate 21 of a solar cell A. The electrode structure 2 is disposed on the light receiving surface of the substrate 21 and includes a plurality of bus bar electrodes 22 and a plurality of finger electrodes 23.

The substrate 21 of the solar cell A is a semiconductor substrate or a photoelectric converting substrate. The semiconductor substrate may further be a single crystal silicon substrate, a polysilicon substrate, or a GaAs substrate. For example, when the substrate 21 is a semiconductor substrate, it includes an N-type semiconductor layer (not shown) and a P-type semiconductor layer (not shown).

The bus bar electrodes 22 are substantially parallel to each other and disposed on the substrate 21. Each bus bar electrode 22 is connected to an external load (not shown). In addition, in the embodiment, the electrode structure 2 includes two bus bar electrodes 22 for example, and the number of the bus bar electrodes 22 may be adjusted according to the demands.

The finger electrodes 23 are disposed over the surface of the N-type semiconductor layer of the substrate 21. Each of the finger electrodes 23 has a first terminal 231 and a second terminal 232. The size d₁ of the first terminal 231 is larger than the size d₂ of the second terminal 232. The finger electrode 23 is connected to two bus bar electrodes 22 by its first terminal 231. The finger electrodes 23 and the bus bar electrode 22 are substantially disposed perpendicular to each other on the substrate 21. Additionally, in the embodiment, the finger electrodes 23 may be, for example but not limited to, trapezoid.

More specifically, in the view of electron flow, firstly, after the substrate 21 receives the solar light, such light energy is photoelectrically converted into a great amount of electrons within the substrate 21. When these electrons reach the surface of the substrate 21, the electrons are collected by the finger electrodes 23 on the substrate 21. The size d₁ of the first terminal 231 of the finger electrode 23 is larger than the size d₂ of the second terminal 232 and the finger electrode 23 is a structure that smoothly and continuously converges from the first terminal 231 to the second terminal 232. Thus, the electrons entering the finger electrode 23 may move from the second terminal 232 to the first terminal 231 when the resistance is lower. Next, since the finger electrode 23 is connected to the bus bar electrode 22 through the first terminal 231 of the finger electrode 23, after the electrons entering the finger electrode 23 move from the second terminal 232 to the first terminal 231, these electrons will be gathered at the bus bar electrode 22 via the first terminal 231. At last, the electrons generated by the photoelectric transduction are transmitted to the outside through the connection between the bus bar electrode 22 and the external load.

It is noted that the finger electrodes 23 are disposed all over the surface of the substrate 21. Hence when it comes to reducing the opacity, the width of the finger electrode 23 should not be too large. The size of the bus bar electrode 22 is significantly larger than that of the finger electrode 23 in actual design of the electrode structure 2. For example, the width d₃ of the bus bar electrode 22 is 2mm, the size d₁ of the corresponding first terminal 231 of the finger electrode 23 is 60µm to 110µm, and the size d₂ of the second terminal 232 is 40µm to 100µm. Therefore, the resistance of the bus bar electrode 22 is significantly lower than that of the finger electrode 23. In addition, the electrons flow from the finger electrode 23 to the bus bar electrode 22. More particularly, the electrons flow from the second terminal 232 to the first terminal 231 of the finger electrode 23 and enter the bus bar electrode 22 from the first terminal 231. Although the preferred ranges of the sizes of the first terminal 231 and the second terminal 232 of the finger electrode 232 are described hereinabove, respectively, the size difference between the first terminal 231 and the second terminal 232 must be between 5µm and 70µm so as to reduce the resistance encountered within the finger electrode 23. Thus, the flow speed of the electrons may be accelerated because of the structures of the first terminal 231 and the second terminal 232. In other embodiments, the electrode structure may change the number of the bus bar electrodes according to different demands. For example, the electrode structure may include a single bus bar electrode, three bus bar electrodes, or more. For substrates with the same size, when the number of the bus bar electrodes is more than 2, the width may be less than 2µm (e.g. the possible width may be 1.5µm or less). It is for sure that when the number of the bus bar electrodes is less than 2, the width may be larger than 2µm (e.g. the possible width may be 2.5µm or larger). To sum up, the number and width of the bus bar electrodes in the electrode structure may be designed to fit different needs.

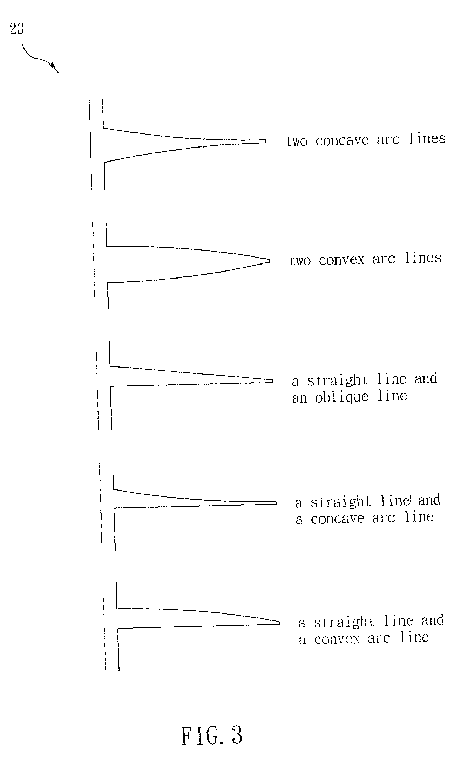

FIG. 3 illustrates various aspects of the finger electrodes 23. With reference to FIG. 3, the finger electrode 23 may be an aspect formed by any two of a concave arc line, a convex arc line, a straight line, and an oblique line. For example, the finger electrode 23 may be formed by two concave arc lines, two convex arc lines, a straight line and an oblique line, a straight line and a concave arc line, or a straight line and a convex arc line.

At the same time, the present invention provides a solar cell including a substrate and an electrode structure disposed on the surface of the substrate. The electrode structure includes a plurality of bus bar electrodes and a plurality of finger electrodes. The bus bar electrodes are alternately disposed on the substrate. The finger electrodes are disposed on the two sides of the bus bar electrodes. Each finger electrode has a first terminal and a second terminal. The first terminals of the finger electrodes are connected to one of the bus bar electrodes and the size of the first terminal is larger than that of the second terminal. The substrate, bus bar electrode, and finger electrode of the solar cell are disclosed in the previous embodiment, thus a detailed description is omitted herein.

Because the electrical performance of the solar cell is closely related to the light utilization rate and electron transmission resistance, the opacity is reduced by decreasing the width of the finger electrode in prior art. However, when the width of the finger electrode is reduced to a certain extend, the electrons pass through a narrower conductive channel and this leads the resistance value to rise. Meanwhile, the electric energy loss in the electrons is caused during the electron transmission process (e.g. the electric energy is converted into the thermal energy and dispersed). On the contrary, the width of the finger electrode has to be widened to prevent the electric energy loss in the electron from occurring during the transmission process. Nonetheless, the opacity of such finger electrode structure must increase. Therefore, the electrode structure and solar cell of the present invention discloses that the sizes of the first terminals of the finger electrodes must be larger than those of the second terminals, such that the solar cell may effectively reduce the resistance received as the electrons flow without increasing the width of the finger electrode, i.e. maintain a low opacity, by only changing the shape of the finger electrode, which is, the first terminal of the finger electrode is larger than the second terminal. Compared to the prior art, a low opacity and a low resistance may be taken care of by the structural change of the finger electrode, thus the present invention may effectively enhance the photoelectric transduction efficiency of the entire solar cell.
In summary and referring to Fig. 2 an electrode structure 2 is disposed in a substrate 21 of a solar cell. The electrode structure includes a plurality of bus bar electrodes 22 and a plurality of finger electrodes 23. The bus bar electrodes are alternately disposed on the substrate. The finger electrodes are disposed on the two sides of the bus bar electrodes. Each of the finger electrodes has a first terminal 231 and a second terminal 232. The first terminals of the finger electrodes are connected to one of the bus bar electrodes. The size d1 of the first terminal 231 is larger than that size d2 of the second terminal 232.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electrode structure disposed in a substrate of a solar cell, comprising:
a plurality of bus bar electrodes alternately disposed on the substrate; and
a plurality of finger electrodes disposed on two sides of the bus bar electrodes,
wherein each of the finger electrodes comprises a first terminal and a second terminal, the first terminals of the finger electrodes are connected to one of the bus bar electrodes, and the size of the first terminal is larger than the size of the second terminal.

2. The electrode structure according to claim 1, wherein each of the finger electrodes is a structure converging from the first terminal to the second terminal.

3. The electrode structure according to claim 2, wherein the finger electrodes are trapezoid.

4. The electrode structure according to any preceding claim, wherein the size of the first terminal is between 60µm and 110µm.

5. The electrode structure according to any preceding claim, wherein the size of the second terminal is between 40µm and 100µm.

6. The electrode structure according to any preceding claim, wherein the size difference between the first terminal and the second terminal is 5µm to 70µm.

7. A solar cell, comprising:
a substrate; and
an electrode structure disposed on the substrate, comprising:
a plurality of bus bar electrodes alternately disposed on the substrate; and
a plurality of finger electrodes disposed on two sides of the bus bar electrodes,
wherein each of the finger electrodes comprises a first terminal and a second terminal, the first terminals of the finger electrodes are connected to one of the bus bar electrodes, and the size of the first terminal is larger than the size of the second terminal.

8. The solar cell according to claim 7, wherein each of finger electrodes is a structure converging from the first terminal to the second terminal.

9. The solar cell according to claim 8, wherein the finger electrodes are trapezoid.

10. The solar cell according to one of claims 7 to 9, wherein the size of the first terminal is between 60µm and 110µm.

11. The solar cell according to one of claims 7 to 10, wherein the size of the second terminal is between 40µm and 100µm.

12. The solar cell according to one of claims 7 to 11, wherein the size difference between the first terminal and the second terminal is 5µm to 70µm.
